# EUROPÄISCHE PATENTANMELDUNG

(11) **EP 1 225 466 A2**
(43) Veröffentlichungstag der Anmeldung: **24.07.2002**
(21) Anmeldenummer: 01128784.4
(22) Anmeldetag: 04.12.2001
(51) Int. Cl.: G02B 21/18, G02B 21/00

(54) **Anordnung zur visuellen inspektion von substraten**

(30) Priorität: 19.01.2001 DE 10102542
(71) Anmelder: Leica Microsystems Jena GmbH, 07745 Jena (DE)
(72) Erfinder: Karsten, Urban, 07747 Jena (DE)
(74) Vertreter: Reichert, Werner F., Dr.

(57) **Zusammenfassung**

Eine Anordnung zur visuellen Inspektion von Substraten (S) umfaßt ein Mikroskop (2) zur Betrachtung des an einem Inspektionsort (I) befindlichen Substrates (S), mindestens ein neben einem Mikroskopeinblick (2a) angeordnetes Betrachtungsfeld (11) zur Betrachtung eines Bildes oder eines Bildausschnittes des Substrates (S) und/oder mindestens ein neben dem Mikroskopeinblick (2a) angeordnetes Betrachtungsfeld (12) zur direkten Betrachtung des Substrates (S) oder eines Teilbereiches des Substrates (S), wobei der Mikroskopeinblick (2a) und die Betrachtungsfelder (11, 12) in bezug auf eine Bedienungsposition (P) derart angeordnet sind, daß von der Bedienungsposition (P) aus in einer ersten Betrachtungsrichtung (A) senkrecht auf den Mikroskopeinblick (2a) und in mindestens einer weiteren Betrachtungsrichtung (B, B') jeweils etwa senkrecht auf eines der Betrachtungsfelder (11, 12) geblickt wird. Dabei schließen die erste Betrachtungsrichtung (A) und die Betrachtungsrichtungen (B, B') spitze Winkel (α, α') ein. Damit wird eine Inspektionsanordnung geschaffen, die sich durch günstige ergonomische Eigenschaften und eine kompakte Bauweise auszeichnet.

## Beschreibung

Die Erfindung bezieht sich auf eine Anordnung zur visuellen Inspektion von Substraten, ausgestattet mit einem Mikroskop zur Betrachtung eines Teilabschnittes des an einem Inspektionsort befindlichen Substrates.

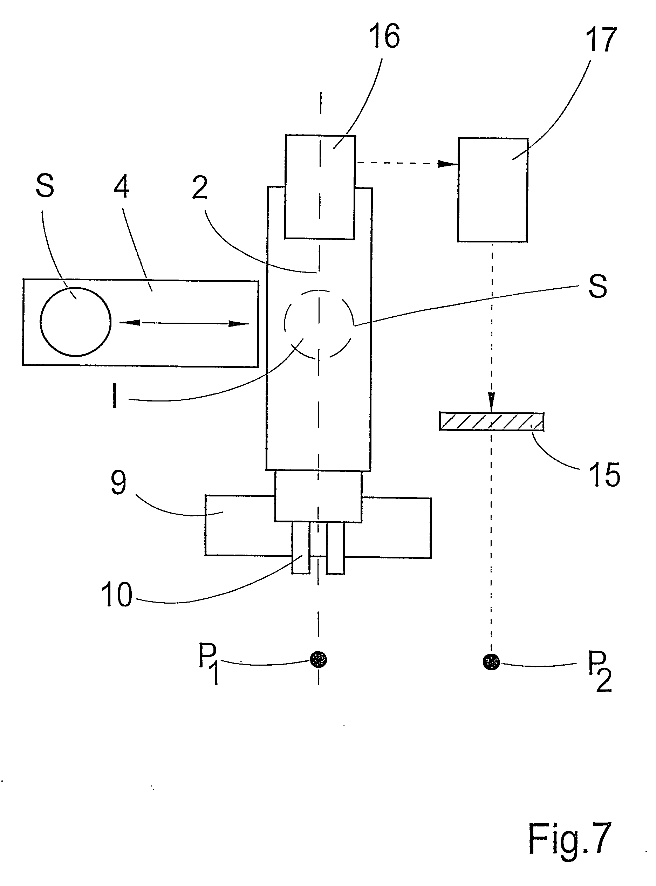

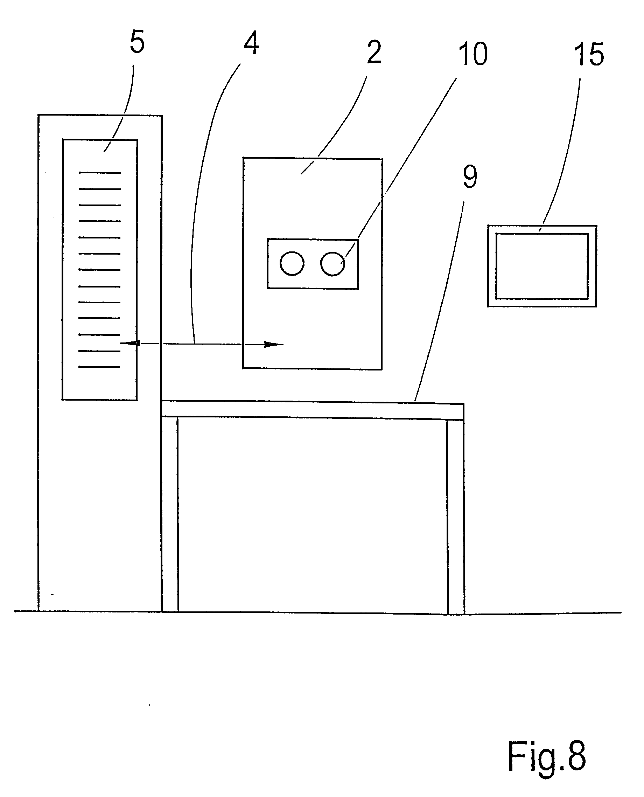

Derartige Anordnungen werden insbesondere bei der Halbleiterherstellung zur Inspektion von Wafern eingesetzt, um diese auf Fertigungsfehler zu untersuchen. Eine solche Anordnung wird beispielsweise von der Firma LEICA unter der Bezeichnung INS 3000 vertrieben. Diese Anordnung, die schematisch in Fig.7 und Fig.8 dargestellt ist, umfaßt eine Transporteinrichtung 4, mit welcher Wafer mit Durchmessern von 100 bis 200 mm zu dem Inspektionsort I gefördert werden. An dem Inspektionsort I kann der zu inspizierende Wafer abschnittsweise mit Hilfe eines Mikroskops betrachtet werden.

Neben dem Mikroskop ist zusätzlich ein Monitor 15 aufgestellt. Auf diesem Monitor 15 wird dem Betrachter ein Funktionsmenü angeboten, das verschiedene Einstelloptionen der Inspektionsanordnung anzeigt, wie beispielsweise die Art und Weise der Beleuchtung für einen zu inspizierenden Wafer oder eine Wahlmöglichkeit für einen Untersuchungsbereich an dem Wafer. Überdies kann auf dem Monitor 15 eine Abbildung des gerade untersuchten Wafers oder eines Teilabschnittes dieses Wafers dargestellt werden, so daß Fehler an dem Wafer auch anhand des Monitorbildes erkannt werden können.

Bei der Inspektion sitzt oder steht ein Bediener vor dem Mikroskop und betrachtet durch dessen Okular 10 den Wafer bzw. den interessierenden Teilabschnittes dieses Wafers. In dieser Betrachtungsposition, die in den Fig.7 und in Fig.8 mit P₁ bezeichnet ist, kann der Bediener über die vor ihm liegende Bedienungskonsole den Betrieb der Inspektionsanordnung, beispielsweise den Vorschub beim Transport eines Wafers in die Inspektionsposition, die Auswahl eines zu untersuchenden Bereiches an dem Wafer und dergleichen steuern, ohne seine Position zu wechseln. Der neben dem Mikroskop aufgestellte Monitor ist jedoch aufgrund seiner parallelen Ausrichtungen zu den Okularen 10 des Mikroskops schlecht einsehbar, da dessen günstigste Betrachtungsposition P₂ erheblich neben der Bedienungsposition P₁ liegt.

Überdies wird bei derartigen Inspektionsanordnungen, wie sie beispielsweise auch unter der Bezeichnung "Optistation 7" der Firma Nikon bekannt sind, der Monitor zu nahe am Bediener angeordnet. Aufgrund des einzuhaltenden Arbeitsabstandes kann in solchen Fällen nur ein verhältnismäßig kleiner Monitor verwendet werden, auf dem sich Details mitunter nur schwer erkennen lassen.

Von diesem Stand der Technik ausgehend liegt der Erfindung die Aufgabe zugrunde, eine Anordnung der eingangs genannten Art unter ergonomischen Gesichtspunkten und mit der Maßgabe einer kompakten Bauweise weiterzuentwickeln.

Dazu ist erfindungsgemäß neben dem Mikroskopeinblick mindestens ein Betrachtungsfeld zur Betrachtung eines Bildes oder eines Bildausschnittes des Substrates und/oder mindestens ein weiteres Betrachtungsfeld zur direkten Betrachtung des Substrates oder eines Teilabschnittes des Substrates vorgesehen. Dabei sind der Mikroskopeinblick und die Betrachtungsfelder in bezug auf eine Bedienungsposition derart angeordnet, daß von der Bedienungsposition aus in einer ersten Betrachtungsrichtung senkrecht auf den Mikroskopeinblick und in mindestens einer weiteren Betrachtungsrichtung jeweils etwa senkrecht auf eines der Betrachtungsfelder geblickt wird. Weiterhin schließt dabei die erste Betrachtungsrichtung mit der bzw. den weiteren Betrachtungsrichtungen jeweils einen spitzen Winkel ein.

Dies ermöglicht der Bedienungsperson ein entspanntes und ermüdungsfreies Arbeiten, da nunmehr aus der Bedienungsposition durch eine leichte Neigung oder Drehung des Kopfes im wesentlichen senkrecht auf die neben dem Mikroskopeinblick vorhandenen Betrachtungsfelder geblickt werden kann. Hieraus resultiert eine bessere Erkennbarkeit im Bereich der Betrachtungsfelder, wodurch sich die Fehlerquote bei der Inspektion der Wafer senken läßt.

Aufgrund der Schrägstellung des Betrachtungsfeldes in bezug auf die Bedienungsposition wird überdies der Abstand zwischen der Bedienungsposition und dem Betrachtungsfeld erhöht, so daß dieses größer als bisher ausgeführt werden kann. Damit lassen sich beispielsweise mehr Bedienungsoptionen anzeigen oder ein größeres Bild des gerade untersuchten Teilbereiches des Substrates darstellen.

In einer besonders vorteilhaften Ausgestaltungsform der Erfindung umfaßt die Anordnung weiterhin ein Gehäuse, das um den Inspektionsort des Mikroskops geschlossen ist. Das Mikroskop ist dabei selbst größtenteils in dem Gehäuse aufgenommen. Weiterhin ist das Betrachtungsfeld bzw. sind die Betrachtungsfelder in eine der Außenwände des Gehäuses integriert. Diese Kapselung ist nicht nur unter dem Gesichtspunkt des äußeren Erscheinungsbildes ansprechend, sondern ermöglicht vor allem auch eine Inspektion der Substrate unter erhöhten Reinheitsbedingungen. So kann beispielsweise ein erhöhter Reinheitsgrad auf den Innenraum des Gehäuses beschränkt werden. Weiterhin wird durch die Kapselung die Gefahr von Fehlbedienungen oder Störeingriffen bei der Positionierung der Substrate an dem Inspektionsort des Mikroskops verhindert. Überdies trägt die Kapselung zu einer Erhöhung der Arbeitssicherheit für den Bediener bei.

In einer weiteren, vorteilhaften Ausgestaltung der Erfindung ist zusätzlich eine Fördereinrichtung zum Transport der Substrate zu dem Inspektionsort hin und von diesem weg vorgesehen. Die Steuerbefehle für die Fördereinrichtung, die innerhalb des Gehäuses angeordnet ist, können über die Bedienungskonsole eingegeben werden.

Weiterhin kann wenigstens ein Magazin zur Aufnahme der Substrate in die Anordnung integriert werden, wobei zusätzlich eine Übergabeeinrichtung zum Transferieren von Substraten zwischen dem Magazin und der Fördereinrichtung vorgesehen ist. Hierdurch wird eine vollständig geschlossene Baueinheit zur Substratinspektion geschaffen, die beispielsweise in der Umgebung einer Waferfertigungslinie aufgestellt werden kann. Vorzugsweise kommen dabei Wechselmagazine zum Einsatz, wodurch ein schneller Austausch der zu untersuchenden Substrate möglich ist. Dabei können das bzw. die Magazine als separate Module ausgebildet werden, die an das Gehäuse der Inspektionsanordnung ankoppelbar sind.

Für eine ergonomisch günstige Anordnung des bzw. der Betrachtungsfelder ist es weiterhin vorteilhaft, wenn die erste Betrachtungsrichtung mit den weiteren Betrachtungsrichtungen einen Winkel kleiner als 50° einschließt, wobei die Bedienungsposition etwa im Scheitelpunkt liegt. In der Praxis haben sich Winkel im Bereich von 30° bis 40° als ergonomisch besonders günstig erwiesen.

In einer besonders vorteilhaften Ausgestaltung ist in der Horizontalrichtung zu beiden Seiten des Mikroskopeinblicks jeweils ein Betrachtungsfeld angeordnet. Damit ist aus der Bedienungsposition gewissermaßen eine Panoramasicht möglich, bei der die Blickwinkel am natürlichen Blickfeld des Bedieners orientiert sind.

Vorzugsweise werden die beiden Betrachtungsfelder ergonomisch günstig auf gleicher Betrachtungshöhe positioniert. Zudem können die jeweiligen Betrachtungsrichtungen auf die Betrachtungsfelder mit der ersten Betrachtungsrichtung, also auf den Mikroskopeinblick, gleiche Winkel einschließen. Hierdurch ergibt sich eine symmetrische Anordnung in bezug auf das in der Mitte angeordnete Mikroskop.

Es ist jedoch nicht notwendig, zwei Betrachtungsfelder vorzusehen.

Bevorzugt wird in einem Betrachtungsfeld ein Monitor angeordnet, auf dem ein Bild oder Bildausschnitt des Substrates visualisierbar ist. Damit läßt sich das Substrat bzw. ein Ausschnitt desselben mit besonders hoher Genauigkeit analysieren. In einer besonders einfachen Ausführungsvariante dient allein dieser Monitor dazu, Informationen über das zu inspizierende Substrat zu erhalten.

Prinzipiell ist es möglich, auf dem Monitor Abbildungen des Substrates darzustellen, die außerhalb des Inspektionsortes des Mikroskops gewonnen werden. In einer besonders vorteilhaften Ausgestaltung der Erfindung werden jedoch auf dem Monitor Abbildungen des Substrates bzw. von Teilen desselben mit Hilfe des Mikroskops erzeugt. Hierzu ist das Mikroskop mit einer opto-elektronischen Kamera gekoppelt und diese über eine elektronische Bildverarbeitungseinrichtung mit dem Monitor verbunden.

In einer weiteren Ausgestaltung der Erfindung ist ein Betrachtungsfeld als Durchsichtscheibe ausgebildet, durch welche unmittelbar auf eine Substratposition geblickt wird. Damit kann beispielsweise der Transport der Substrate in die Inspektionsposition auf einfache Art und Weise beobachtet und überwacht werden.

Im Sichtbereich des Betrachtungsfeldes hinter der Durchsichtscheibe kann ein Wobbler mit einem Teller zum Halten eines Substrates angeordnet sein. Dieser Teller ist um eine Drehachse drehbar und zu der Drehachse neigbar. Bei einer Drehung des Tellers vollführt ein auf diesem gehaltenes Substrat eine Taumelbewegung, so daß aus der Bedienungsposition das Substrat unter verschiedenen Blickwinkeln betrachtet werden kann. Hierdurch lassen sich insbesondere Verunreinigungen, wie beispielsweise Staubpartikel oder auch Kratzer auf dem Substrat als Fehler verifizieren.

Wird der Inspektionsbereich über das Mikroskop erfaßt und auf einem Monitor dargestellt, so ist es nicht unbedingt erforderlich, den Mikroskopeinblick zur Inspektion zu benutzen. Zumeist ist jedoch die Beobachtungsmöglichkeit durch das Mikroskop erwünscht und das Mikroskop vorzugsweise als Stereomikroskop mit zwei Okularen ausgebildet.

Aus Gründen der Ergonomie werden die Okulare und die Betrachtungsfelder vorzugsweise auf einer Höhe angeordnet. Die Bedienungsperson kann dadurch bei geringer Kopfbewegung die Betrachtungsrichtungen schnell wechseln und entweder durch die Okulare oder, für einen schnellen Kontrollblick, auf das bzw. die Betrachtungsfelder blicken.

Um ein zu weites Vorbeugen über die Bedingungskonsole und eine ungünstige Körperhaltung der Bedienungsperson bei der Inspektion zu vermeiden, erstrecken sich die Okulare vorzugsweise bis über die Bedienungskonsole. Für eine kompakte Bauweise ist es vorteilhaft, die Bedienungskonsole möglichst nahe an dem Gehäuse anzuordnen. Um in diesem Fall dennoch einen ausreichenden Betrachtungsabstand zu den Betrachtungsfeldern zu ermöglichen, sind diese in einer Vertiefung der Außenwand des Gehäuses angeordnet. Um ein schnelles Wechseln der Betrachtungsrichtung zu ermöglichen, wird zwischen den Okularen und einem Betrachtungsfeld jeweils ein Abstand von vorzugsweise etwa 30 cm vorgesehen.

Die Erfindung wird nachfolgend anhand von Ausführungsbeispielen näher erläutert. Die zugehörigen Zeichnungen zeigen in:
- Fig.1: eine schematische Darstellung eines ersten Ausführungsbeispiels einer erfindungsgemäßen Inspektionsanordnung in einer Draufsicht,
- Fig.2: eine Seitenansicht auf die Inspektionsanordnung aus Fig.1,
- Fig.3.: eine schematische Darstellung eines zweiten Ausführungsbeispiels einer erfindungsgemäßen Inspektionsanordnung in einer Draufsicht,
- Fig.4: eine Seitenansicht auf die Inspektionsanordnung aus Fig.3,
- Fig.5: eine schematische Darstellung eines dritten Ausführungsbeispiels einer Inspektionsanordnung nach der Erfindung in einer Draufsicht,
- Fig.6: eine Seitenansicht der Inspektionsanordnung aus Fig.5,
- Fig.7: eine Draufsicht auf eine bereits bekannte Inspektionsanordnung und in
- Fig.8: eine Seitenansicht auf die bekannte Inspektionsanordnung aus Fig. 7.

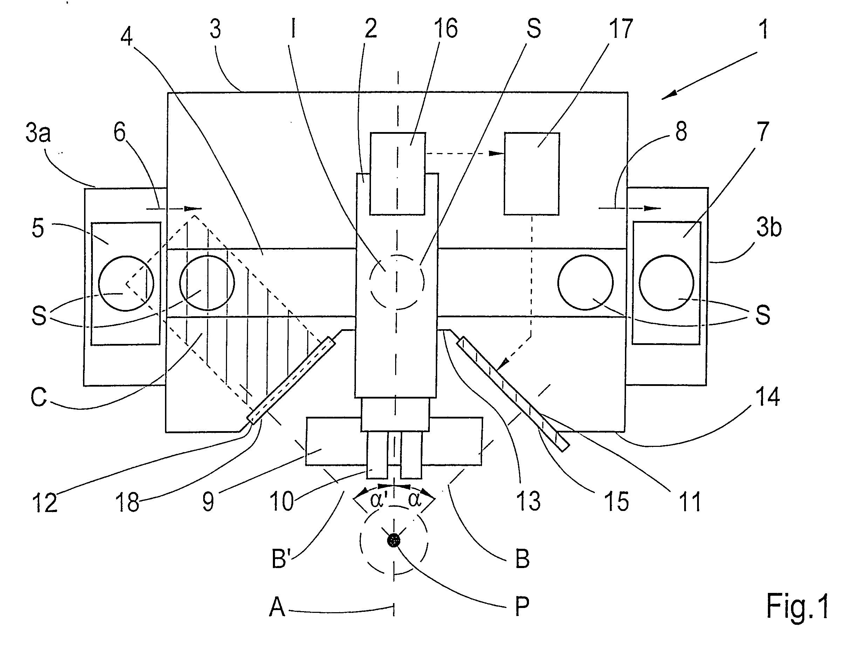

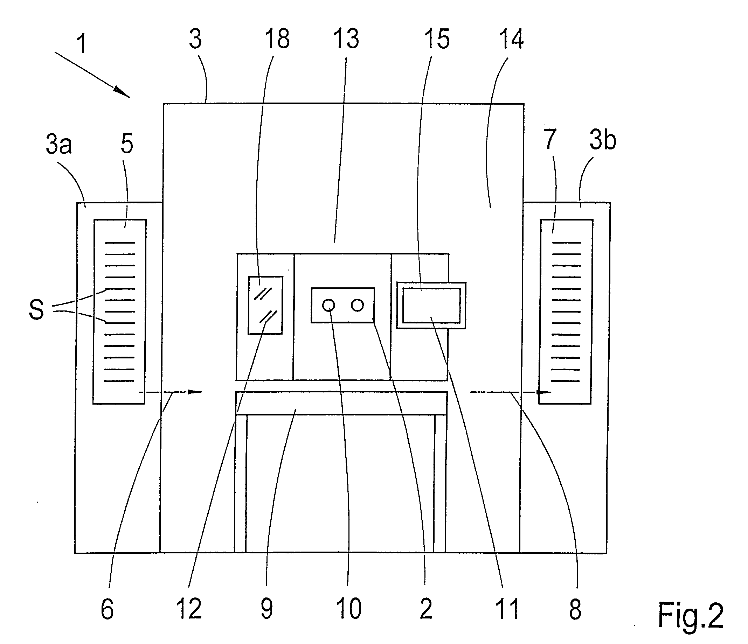

Das erste Ausführungsbeispiel in Fig.1 und Fig.2 zeigt eine Inspektionsanordnung 1, mit der flächenhafte Substrate S, beispielsweise Wafer, mikroskopisch untersucht werden können. Insbesondere lassen sich mit der Inspektionsanordnung 1 bei der Fertigung als fehlerhaft beurteilte und ausgesonderte Wafer näher untersuchen, beispielsweise um die Fehlerursache zu ergründen.

Die Inspektionsanordnung 1 umfaßt ein Beobachtungsinstrument, insbesondere ein Mikroskop 2 mit einem Mikroskopeinblick 2a, das auf ein an einem Inspektionsort I befindliches Substrat S, hier einen Wafer, ausrichtbar ist. Der Inspektionsort I ist von einem Gehäuse 3 umschlossen, in dem gleichzeitig auch das Mikroskop 2 aufgenommen ist. In dem Gehäuse 3 ist weiterhin eine Fördereinrichtung 4 zum Transport der Substrate (S) zu dem Inspektionsort (I) hin und von diesem weg vorgesehen.

Die Inspektionsanordnung 1 umfaßt weiterhin ein erstes Magazin 5 zur Aufnahme mehrere Substrate S. Weiterhin ist eine Übergabeeinrichtung 6 vorgesehen, welche die Substrate S von dem ersten Magazin 5 an die Fördereinrichtung 4 übergibt. Nach der Inspektion werden die Substrate S in einem zweiten Magazin 7 gesammelt. Eine weitere Übergabeeinrichtung 8 dient dazu, die Substrate S von der Fördereinrichtung 4 in das zweite Magazin 7 zu transferieren.

Bevorzugt sind die Magazine 5 und 7 als Wechselmagazine ausgebildet, in denen die Substrate S übereinander gestapelt werden. Jedes der Magazine 5 und 7 ist dazu gesondert an das Gehäuse 3 angekoppelt. Es ist auch möglich, jedes der Magazine in ein zusätzliches Gehäusemodul 3a bzw. 3b zu integrieren. Die zusätzlichen Gehäusemodule 3a und 3b können je nach den Gegebenheiten des Aufstellungsortes an unterschiedlichen Seiten des Gehäuses 3 angekoppelt werden, wobei die Fördereinrichtung 4 dann entsprechend angepaßt wird.

Bei geeigneter Gestaltung des Transportweges der Substrate S zu dem Inspektionsort I können die Magazine 5 und 7 auch in einem gemeinsamen Gehäusemodul aufgenommen werden. Überdies ist es möglich, lediglich ein einziges Magazin zu verwenden, aus dem die Substrate S zu dem Inspektionsort und von dort zurück in das Magazin transportiert werden.

Weiterhin umfaßt die Inspektionsanordnung 1 eine Bedienungskonsole 9, die an einer Seite des Gehäuses 3 bei der Bedienungsposition P angeordnet ist. Dazu sind an dem aus dem Gehäuse 3 hinausragenden Mikroskopeinblick 2a zwei Okulare 10 vorgesehen, welche sich über die Bedienungskonsole 9 erstrecken. Damit ist aus der Bedienungsposition P ein entspanntes und wenig ermüdendes Arbeiten möglich. Insbesondere muß sich die Bedienungsperson beim Blick durch die Okulare 10 nicht weit über die Bedienungskonsole 9 vorlehnen, sondern kann vielmehr in einer im wesentlichen aufrechten Körperhaltung verbleiben.

Neben dem Mikroskopeinblick 2a sind am Gehäuse 3 ein Betrachtungsfeld 11 zur Darstellung eines Bildes oder eines Bildausschnittes des Substrates (S) und ein Betrachtungsfeld 12 zur direkten Betrachtung des Substrates (S) oder eines Teilbereiches des Substrates (S) vorgesehen. Die beiden Betrachtungsfelder 11 und 12 sind in bezug auf die Bedienungsposition P derart geneigt, daß eine vor dem Mikroskopeinblick 2a befindliche Bedienungsperson im wesentlichen senkrecht auf das jeweilige Betrachtungsfeld 11 bzw. 12 blickt.

Wie insbesondere Fig.2 entnommen werden kann, liegen die beiden Betrachtungsfelder 11 und 12 mit dem Mikroskopeinblick 2a bzw. den Okularen 10 auf gleicher Höhe, so daß sich für eine Bedienungsperson in der Bedienungsposition P eine Art Panoramablick ergibt.

Die Schrägstellung der Betrachtungsfelder 11 und 12 wird durch eine im Profil etwa trapezförmige Vertiefung 13 in der Außenwand 14 des Gehäuses 3 erreicht. Die Betrachtungsfelder 11 und 12 sind zu dem Mikroskopeinblick 2a derart angeordnet, daß in einer ersten Betrachtungsrichtung A senkrecht auf den Mikroskopeinblick 2a und in weiteren Betrachtungsrichtungen B bzw. B' senkrecht auf das jeweilige Betrachtungsfeld 11 bzw. 12 geblickt wird. Die erste Betrachtungsrichtung A und die jeweilige weitere Betrachtungsrichtung B bzw. B' schließen jeweils einen spitzen Winkel α bzw. α' ein, wobei die Bedienungsposition P den Scheitel dieser Winkel bildet. In dem dargestellten Ausführungsbeispiel liegen die Winkel α bzw. α' jeweils im Bereich von 30° bis 40°. Die Bedienungsperson hat somit aus der Bedienungsposition P beide Betrachtungsfelder 11 und 12 im Blick.

In dem ersten Ausführungsbeispiel ist im Betrachtungsfeld 11 ein Monitor 15 angeordnet, beispielsweise ein 21"-LC-Display, auf dem ein Bedienungsmenü angezeigt werden kann. Weiterhin wird dieser Monitor 15 dazu verwendet, eine Abbildung des zu inspizierenden Substrates S oder des Teilbereiches des Substrates S, das sich gerade an dem Inspektionsort I befindet, darzustellen. Zu diesem Zweck ist, ebenfalls innerhalb des Gehäuses 3, eine mit dem Mikroskop gekoppelte Bilderfassungseinrichtung 16 in Form einer Kamera vorgesehen. Die mittels der Bilderfassungseinrichtung 16 von einem Substrat S aufgenommenen Bildinformationen werden an eine elektronische Bildverarbeitungseinrichtung 17 übertragen und dort in das Darstellungsformat des Monitors 15 umgesetzt.

Die Darstellung auf dem Monitor kann im Wechsel mit dem Bedienungsmenü erfolgen. Es ist jedoch auch möglich, das Bild des gerade untersuchten Teilbereiches auf einem Flächenabschnitt des Monitors 15 neben dem Bedienungsmenü darzustellen.

Weiterhin ist es möglich, mehrere Betrachtungsfelder 11 mit Monitoren vorzusehen, wobei dann beispielsweise auf einem Monitor das Bedienungsmenü und auf einem anderen Monitor das Bild eines Substrates S dargestellt wird.

In dem ersten Ausführungsbeispiel nach Fig.1 und Fig.2 ist jedoch nur ein Betrachtungsfeld 11 mit einem Monitor vorgesehen und das zweite Betrachtungsfeld 12 als Durchsichtscheibe 18 ausgebildet. Prinzipiell kann anstelle der Durchsichtscheibe 18 eine einfache Öffnung im Gehäuse 3 vorhanden sein. Die Durchsichtscheibe 18 ermöglicht jedoch eine vollständige Kapselung des Gehäuses 3.

Durch die Durchsichtscheibe 18 hindurch kann aus der Bedienungsposition P die Zuführung der Substrate S zu dem Inspektionsort I überwacht werden. Weiterhin ist es möglich, im Sichtbereich C des Betrachtungsfeldes 12 innerhalb des Gehäuses 3 einen sogenannten Wobbler anzuordnen. Dieser umfaßt u.a. einen Teller zum Halten eines Substrates S bzw. Wafers. Dieser nicht dargestellte Teller ist um eine Achse drehbar. Gleichzeitig ist der Teller zu der Drehachse geneigt, so daß bei einer Rotation des Tellers ein aufgelegtes Substrat S eine Taumelbewegung vollführt. Durch eine geeignete Beleuchtung des auf dem Teller befindlichen Substrates S kann die Bedienungsperson grobe Oberflächenfehler an dem Substrat, wie beispielsweise Kratzer oder Farbmuster erkennen. Überdies sind auch an dem Substrat S anhaftende Partikel, beispielsweise Staubkörner wahrnehmbar und so als Fehlerquellen identifizierbar.

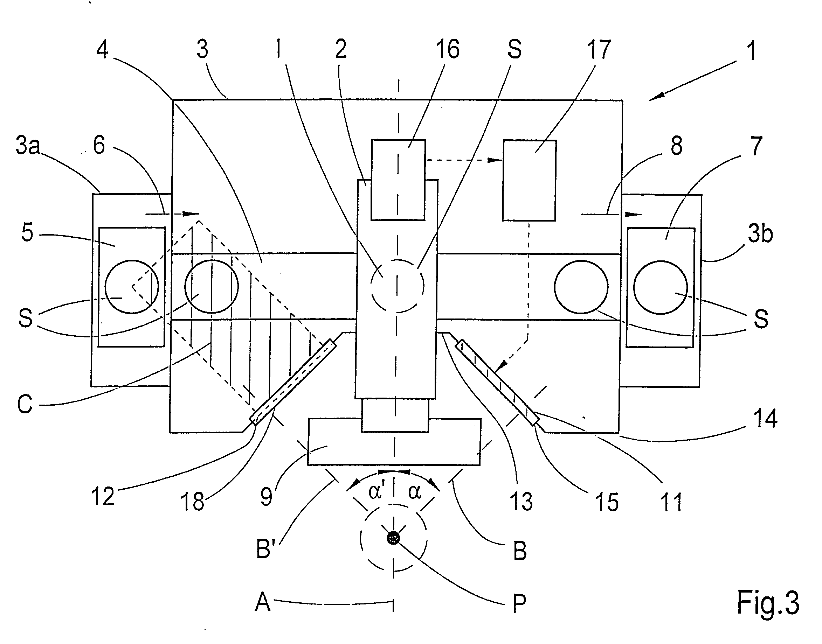

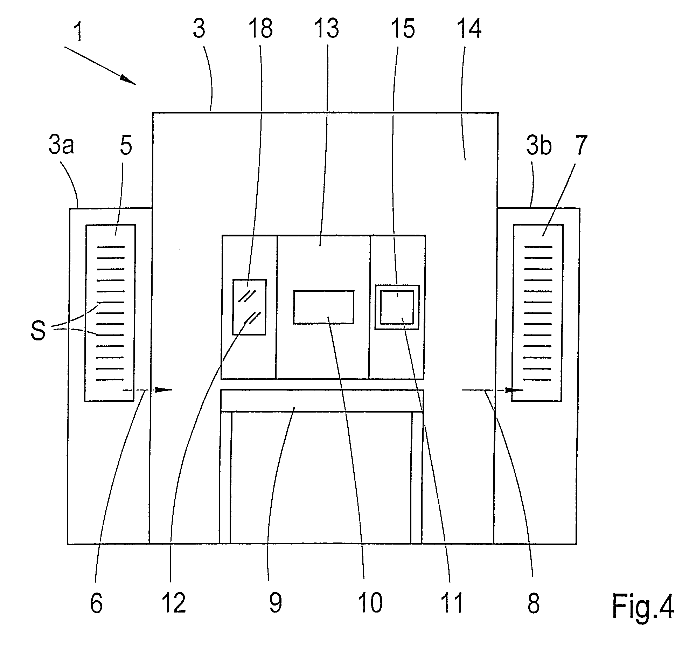

Fig.3 und Fig.4 zeigen ein zweites Ausführungsbeispiel einer Inspektionsanordnung 1, das im wesentlichen dem ersten Ausführungsbeispiel nach Fig.1 und Fig.2 entspricht, jedoch entfallen hier die Okulare 10 zur unmittelbaren visuellen Betrachtung eines Substrates S. Die entsprechenden Informationen werden in diesem Falle allein auf dem Monitor 15 abgelesen.

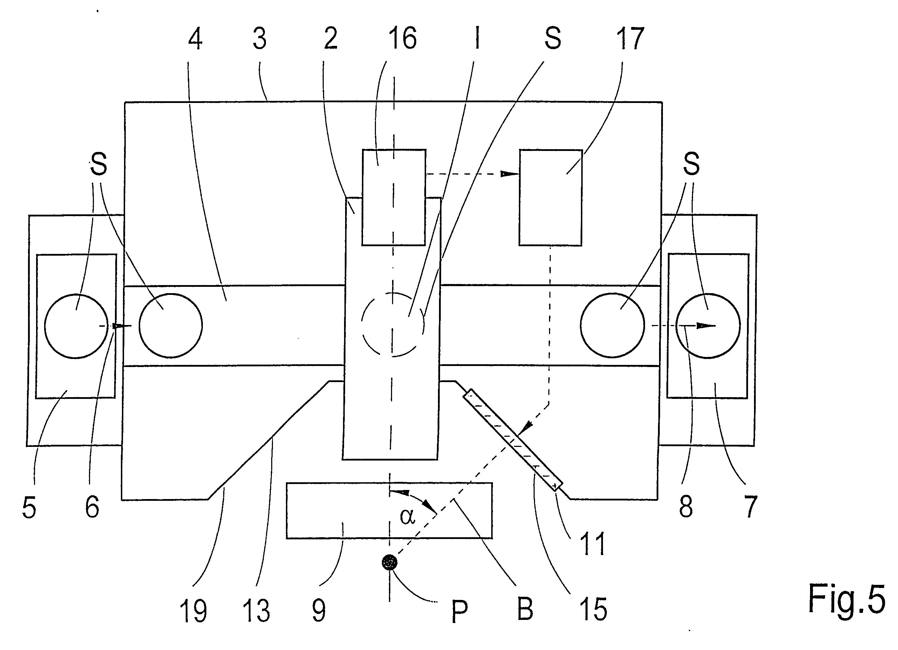

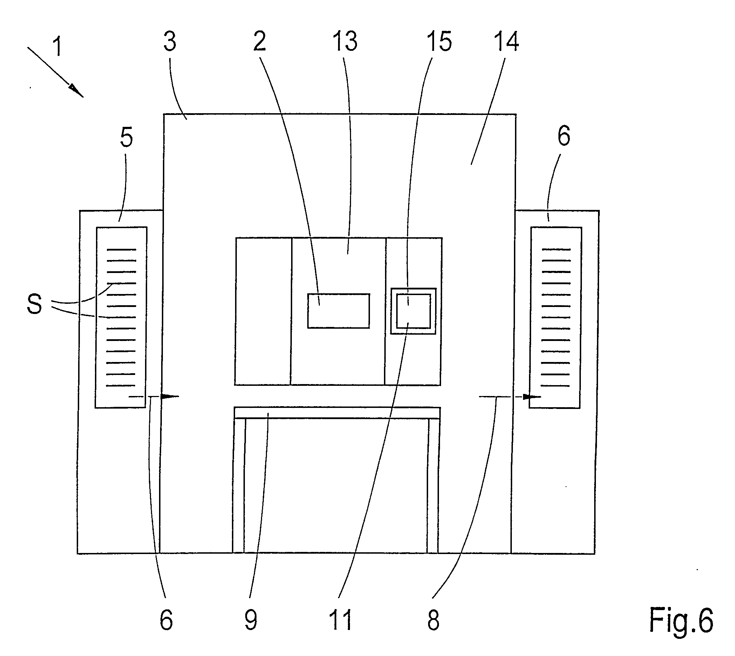

Eine weiter vereinfachte Inspektionsanordnung 1 ist als drittes Ausführungsbeispiel in Fig.5 und Fig.6 dargestellt. Hier ist anstelle der Durchsichtscheibe 18 ein geschlossener Wandabschnitt 19 vorgesehen; die direkte Sicht auf das Substrat S ist hier nicht möglich.

In einer weiteren Abwandlung der vorgenannten Ausführungsbeispiele kann die Bedienungskonsole 9 auch in das Gehäuse 3 integriert werden. Überdies ist es möglich, die Bedienungskonsole 9 abnehmbar auszugestalten, so daß diese nicht zwingend bei der Bedienungsposition P angeordnet werden muß. In jedem Fall ist jedoch zu gewährleisten, daß die über die Bedienungskonsole 9 eingegebenen Steuerbefehle an die Inspektionsanordnung 1 übertragen werden.

Die erläuterten Inspektionsanordnungen zeichnen sich alle durch gute ergonomische Eigenschaften und eine kompakte Bauweise aus.

### Bezugszeichenliste

- 1: Inspektionsanordnung
- 2: Mikroskop
- 2a: Mikroskopeinblick
- 3: Gehäuse
- 4: Fördereinrichtung
- 5: erstes Magazin
- 6: Übergabeeinrichtung
- 7: zweites Magazin
- 8: Übergabeeinrichtung
- 9: Bedienungskonsole
- 10: Okulare
- 11: Betrachtungsfeld
- 12: Betrachtungsfeld
- 13: Vertiefung
- 14: Außenwand
- 15: Monitor
- 16: Bilderfassungseinrichtung
- 17: Bildverarbeitungseinrichtung
- 18: Durchsichtscheibe
- 19: geschlossener Wandabschnitt
- A: erste Betrachtungsrichtung
- B, B': weitere Betrachtungsrichtungen
- C: Sichtbereich
- I: Inspektionsort
- P, P₁, P₂: Bedienungsposition
- S: Substrat
- α, α': Winkel

## Patentansprüche

1. Anordnung zur visuellen Inspektion von Substraten, umfassend:
ein Mikroskop (2) zur Betrachtung des an einem Inspektionsort (I) befindlichen Substrates (S),
mindestens ein neben einem Mikroskopeinblick (2a) angeordnetes Betrachtungsfeld (11) zur Betrachtung eines Bildes oder eines Bildausschnittes des Substrates (S) und/oder
mindestens ein neben dem Mikroskopeinblick (2a) angeordnetes Betrachtungsfeld (12) zur direkten Betrachtung des Substrates (S) oder eines Teilbereiches des Substrates (S),
wobei der Mikroskopeinblick (2a) und die Betrachtungsfelder (11, 12) in bezug auf eine Bedienungsposition (P) derart angeordnet sind, daß von der Bedienungsposition (P) aus in einer ersten Betrachtungsrichtung (A) senkrecht auf den Mikroskopeinblick (2a) und in mindestens einer weiteren Betrachtungsrichtung (B, B') jeweils etwa senkrecht auf eines der Betrachtungsfelder (11, 12) geblickt wird, und wobei die erste Betrachtungsrichtung (A) mit der bzw. den weiteren Betrachtungsrichtungen (B, B') jeweils einen spitzen Winkel (α, α') einschließt.

2. Anordnung nach Anspruch 1 mit einem Gehäuse (3), das den Inspektionsort (I) umschließt, wobei das Mikroskop (2) zum Teil von dem Gehäuse (3) umschlossen ist und die Betrachtungsfelder (11, 12) in einer Außenwand (14) des Gehäuses (3) positioniert sind.

3. Anordnung nach Anspruch 1 oder 2 mit einer bei der Bedienungsposition (P) angeordneten Bedienungskonsole (9) zur Eingabe von Steuerbefehlen für das Mikroskop (2) und/oder für eine Fördereinrichtung (4) zum Transport der Substrate (S) zu dem Inspektionsort (I) hin und von diesem weg.

4. Anordnung nach einem der vorgenannten Ansprüche, **dadurch gekennzeichnet, daß** die erste Betrachtungsrichtung (A) mit den weiteren Betrachtungsrichtungen (B, B') jeweils Winkel (α, α') kleiner als 50° einschließt.

5. Anordnung nach einem der vorgenannten Ansprüche, **dadurch gekennzeichnet, daß** in Horizontalrichtung zu beiden Seiten des Mikroskopeinblicks (2a) jeweils eines der Betrachtungsfelder (11, 12) vorgesehen ist.

6. Anordnung nach Anspruch 5, **dadurch gekennzeichnet, daß** die beiden Betrachtungsfelder (11, 12) auf einer gleichen Betrachtungshöhe positioniert sind.

7. Anordnung nach einem der vorgenannten Ansprüche, **dadurch gekennzeichnet, daß** das Betrachtungsfeld (11) als Monitor (15) ausgebildet ist, auf dem das Bild oder der Bildausschnitt des Substrates (S) dargestellt ist.

8. Anordnung nach Anspruch 7, **dadurch gekennzeichnet, daß** das Mikroskop (2) mit einer opto-elektronischen Bilderfassungseinrichtung (16) gekoppelt und diese über eine elektronische Bildverarbeitungseinrichtung (17) mit dem Monitor (15) verbunden ist.

9. Anordnung nach Anspruch einem der vorgenannten Ansprüche, **dadurch gekennzeichnet, daß** das Betrachtungsfeld (12) als Durchsichtscheibe (18) ausgebildet ist, durch welche hindurch das Substrat (S) oder ein Teilbereich des Substrates (S) unmittelbar sichtbar ist.

10. Anordnung nach Anspruch 9, **dadurch gekennzeichnet, daß** in einem Sichtbereich (C) des Betrachtungsfeldes (12) ein Drehteller zur Aufnahme eines der Substrate (S) positioniert ist, der zu seiner Drehachse neigbar ist.
